**Europäisches Patentamt**

**European Patent Office**

**Office européen des brevets**

(19)

(11) **EP 1 227 556 A2**

(12) **EUROPEAN PATENT APPLICATION**

(43) Date of publication:
**31.07.2002 Bulletin 2002/31**

(51) Int Cl.7: **H01S 5/12**

(21) Application number: **02001614.3**

(22) Date of filing: **23.01.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **24.01.2001 JP 2001015523**
**07.08.2001 JP 2001238967**

(71) Applicant: **THE FURUKAWA ELECTRIC CO., LTD.**
**Tokyo (JP)**

(72) Inventors:
• **Kise, Tomofumi**
**c/o The Furukawa Electric Co., Ltd.**
**Tokyo (JP)**
• **Funabashi, Masaki**
**c/o The Furukawa Elect. Co.,Ltd.**
**Tokyo (JP)**

(74) Representative: **Pätzold, Herbert, Dr.-Ing.**
**Steubstrasse 10**
**82166 Gräfelfing (DE)**

(54) **Complex-coupled distributed feedback semiconductor laser device**

(57) A complex-coupled DFB laser device (10) including a resonant cavity, and a diffraction grating (20) and an active layer (16) disposed in the resonant cavity, the diffraction grating (20) including alternately a grating layer (20c) having an absorption layer (20a) for absorbing laser having an emission wavelength of the resonant cavity, and a buried layer (22) filled in a space around the grating layer (20c) and formed by a material having an equivalent refractive index higher than that of the grating layer (20c) and a bandgap wavelength smaller than that of the active layer (16). The DFB laser can be realized lasing in the single mode at the longer wavelength side than the Bragg's wavelength, and scarcely generates the multi-mode lasing and the mode hopping irrespective of a higher injection current.

## FIG. 2

**EP 1 227 556 A2**

**Description**

BACKGROUND OF THE INVENTION

FIELD OF THE INVENTION

The present invention relates to a distributed feedback semiconductor laser device, and more particularly to the complex-coupled distributed feedback semiconductor laser device having an excellent single mode property, wherein the single mode lasing property is not disturbed as by multi-mode lasing and mode hopping phenomena irrespective of a higher injection current.

DISCUSSION OF THE BACKGROUND

A distributed feedback semiconductor laser device (hereinafter referred to as "DFB laser") includes, in a resonant cavity, a structure having the real part and/ or the imaginary part of a complex refractive index which periodically changes. The structure is generally referred to as a diffraction grating. In the DFB laser, only a specified emission wavelength is subjected to the feedback in accordance with the function of the diffraction grating.

The DFB lasers are categorized into three types including a refractive index-coupled DFB laser, a gain-coupled DFB laser and a complex-coupled DFB laser.

The complex-coupled DFB laser in which both of the real part and the imaginary part of the complex refractive index are periodically changed with location is a semiconductor laser having both of a large distribution feedback and a single mode property, and is classified into an in-phase subtype and an anti-phase subtype.

The in-phase subtype is the DFB laser structure in which the real part of the complex refractive index of the diffraction grating is increased where the imaginary part of the complex refractive index is increased (or the gain is increased). On the other hand, the anti-phase subtype is the DFB laser structure in which the real part of the complex refractive index of the diffraction grating is decreased where the imaginary part of the complex refractive index is increased.

For example, the 1.55 μm band InGaAsP/InP-based complex-coupled DFB laser as been proposed including an absorptive diffraction grating having an InGaAs grating layer acting as the diffraction grating and absorbing the emission wavelength, and an InP buried layer.

The diffraction grating of the complex-coupled DFB laser is the anti-phase subtype structure including grating layers each consisting of an InGaAs absorption layer having a relatively large refractive index and an InP-based underlying layer having a refractive index smaller than that of the absorption layer and existing below the absorption layer, and an InP-based buried layer filled in the space between the adjacent grating layers and formed by the material having the same refractive index as that of the underlying layer.

On the other hand, another complex-coupled DFB laser including a gain diffraction grating has been devised which is fabricated by, after the formation of a diffraction grating by etching a part of an InGaAsP active layer acting as an emitting section, filling the diffraction grating with InP having a refractive index smaller than that of the active layer. The DFB laser is the in-phase subtype structure because both of the refractive index and the gain of the InGaAsP active layer acting as the grating layer are larger than those of the InP buried layer around the active layer.

This method is commonly used because of the ease of the crystal growth occurring in the buried layer having the InP composition.

However, the conventional complex-coupled DFB laser including the absorptive diffraction grating has the following problems.

Since the refractive index of the InGaAs layer forming the grating layer of the diffraction grating is larger than the InP forming the buried layer around the grating layer, the anti-phase laser is formed in which the lasing is likely to take place at the shorter wavelength side of the Bragg's wavelength. Accordingly, the stable single mode operation under the higher current injection is difficult to occur, and the phenomenon of disturbing the single mode lasing such as the multi-mode lasing and the mode hopping is liable to occur.

On the other hand, in the complex-coupled DFB laser having the diffraction grating acting as the active layer, the in-phase subtype laser is realized to improve the single mode property. However, the problems arise in connection with deterioration of the characteristics and the reliability such as the increase of the threshold current density of the fabricated laser device and the reduction of the lasing efficiency due to the deterioration of the crystalline generated during the etching of the active layer and the difficulty of the growth control of the buried crystal.

Then, in place of the InP layer buried layer forming the diffraction grating of the above complex-coupled DFB laser, the InGaAsP having the higher refractive index than the InP has been proposed for filling the space around the InGaAs absorptive grating layer, thereby realizing the pure gain-coupled DFB laser to enable the lasing at the Bragg's wavelength by removing the periodical structure of the real part of the complex refractive index.

However, in the above pure gain-coupled DFB laser, the distribution feedback is conducted only by the periodical structure of the imaginary part of the complex refractive index. Accordingly, the problems arise such as weakness of the degree of the distribution feedback, occurrence of the multi-mode lasing, increase of the threshold current and reduction of the lasing efficiency.

SUMMARY OF THE INVENTION

In one aspect of the present invention, a complex-coupled distributed feedback laser device is provided including a resonant cavity, and a diffraction grating and an active layer disposed in the resonant cavity, the diffraction grating including alternately a grating layer having an absorption layer, and a buried layer filled in a space around the grating layer and formed by a material having an equivalent refractive index higher than that of the grating layer and a bandgap wavelength shorter than that of the active layer.

In accordance with the present invention, the complex-coupled DFB laser device can be realized lasing in the single mode at the longer wavelength side than the Bragg's wavelength, and scarcely generates the multi-mode lasing and the mode hopping under the higher current injection.

The above and other objects, features and advantages of the present invention will be more apparent from the following description.

BRIEF DESCRIPTION OF DRAWINGS

Fig.1 is a partially broken perspective view showing a DFB laser in accordance with an embodiment of the present invention.

Figs.2 is a vertical sectional view of the DFB laser of Fig.1 taken along a line I-I.

Fig.3 is a vertical sectional view of a diffraction grating in Figs.1 and 2.

Fig.4 is a graph showing the relation between the depth of a grating layer and the equivalent refractive indexes of the grating layer and a buried layer.

Figs.5A to 5F are vertical sectional views sequentially showing a method for fabricating the DFB laser of the embodiment.

Fig.6A is a diagram showing the relation between the emission wavelength of the DFB laser of the embodiment and a stop band (SB), and Fig.6B is a diagram showing the relation between the emission wavelength of the conventional DFB laser and a stop band.

DESCRIPTION OF THE PREFERRED EMBODIMENTS

In the filed of the optical communication and optical information processing, a communication system is demanded in which a larger amount of data is processed at a higher speed. Also in the semiconductor lasing device, a DFB laser excellent in the single mode property is demanded having the higher reliability for use as an optical source.

The present inventors have investigated improvement of the conventional complex-coupled DEB laser including an absorptive diffraction grating for obtaining advantages of the easier fabrication and the higher product yield compared with the conventional gain-coupled DFB laser though the complex-coupled DEB laser includes the problem of the lasing at the wavelength shorter than the Bragg's wavelength.

Accordingly, an in-phase complex-coupled DFB laser of the present invention has been made in which the lasing is likely to occur at a longer wavelength than the Bragg's wavelength by using an absorptive diffraction grating hardly damaging an active layer for stabilizing a single mode property under higher current injection.

The bandgap wavelength refers to bandgap energy converted into a wavelength or the bandgap wavelength $\lambda g$ ($\mu m$) = 1.24/Eg (eV) wherein Eg is bandgap energy.

The bandgap wavelength of the buried layer is desirably established to be shorter than the emission wavelength by about 100 nm such that the buried layer does not absorb the emission wavelength.

Thereby, the complex-coupled DFB laser is configured as the in-phase subtype laser, and the lasing is likely to occur at the mode having a wavelength longer than the Bragg's wavelength, though the grating is the absorptive diffraction grating, as a result that a coupling constant ($_{ki}$) showing the strength of the distributed feedback in accordance with the real part of the complex refractive index becomes to have a finite value which is not zero.

The DFB laser which stably operates at a higher output can be realized because the single mode property is stabilized, and the multi-mode lasing and mode hopping are difficult to occur even under the higher injected current.

The compositions of the compound semiconductor layer configuring the resonant cavity and of the absorption layer, the grating layer and the buried layer configuring the diffraction grating are not restricted. The grating layer and the buried layer may be a layered structure having two or more layers.

A process of making the equivalent refractive index of the buried layer higher than the equivalent refractive index of the grating layer is not restricted. For example, the grating layer of the diffraction grating is used which is a stacked layer having a thickness of "d" (= $t_1 + t_2$) including an absorption layer having a thickness of "$t_1$" and an underlying layer, under the absorption layer, having a thickness of "$t_2$" and a refractive index smaller than that of the absorption layer. The buried layer is formed by a material having an equivalent refractive index smaller than the refractive index of the absorption layer and larger than the refractive index of the underlying layer. The etching depth and the refractive index are established such that the following relation holds, wherein $n_b$, $n_a$ and $n_u$ are an equivalent refractive index of the buried layer, a refractive index of the absorption layer and a refractive index of the underlying layer;

$$d \times n_b > t_1 \times n_a + (d - t_1) \times n_u.$$

The grating layer of the diffraction layer may be a three-layered structure having a thickness of "d" including a top layer having a thickness of "$d - t_1 - t_2$" in addition to the absorption layer and the underlying layer.

In this case, the buried layer is formed of one or more compound semiconductor layers made by the material having the equivalent refractive index smaller than that of the absorption layer and higher than that of the underlying layer, and the following relation holds, wherein $n_t$ is a refractive index of the top layer.

$$d \times n_b > t_1 \times n_a + (d - t_1) \times n_u + (d - t_1 - t_2) \times n_1.$$

The higher output of the DFB laser can be easily attained suitably by covering the one end of the resonant cavity with an anti-reflection film (less than 5% reflectivity) and the other end with a high reflection film (greater than 80% reflectivity).

Then, the configuration of a DFB laser device in accordance with embodiments of the present invention will be described referring to the annexed drawings.

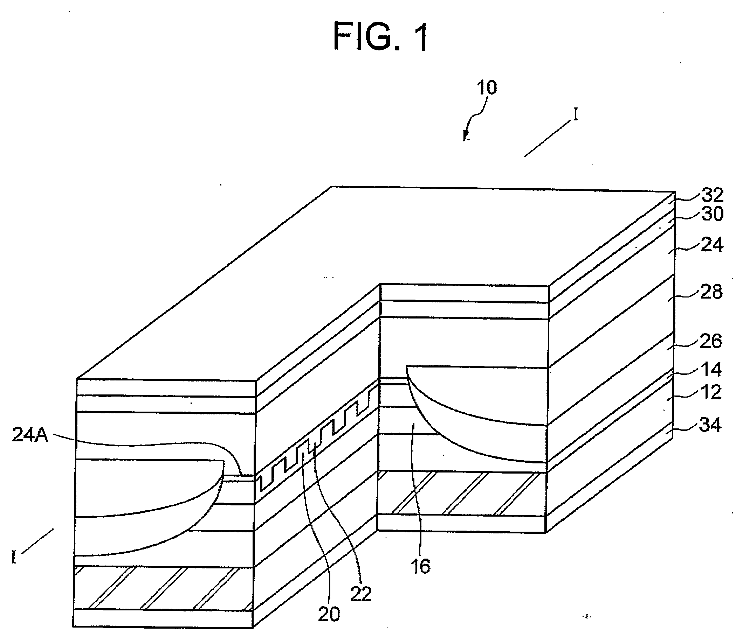

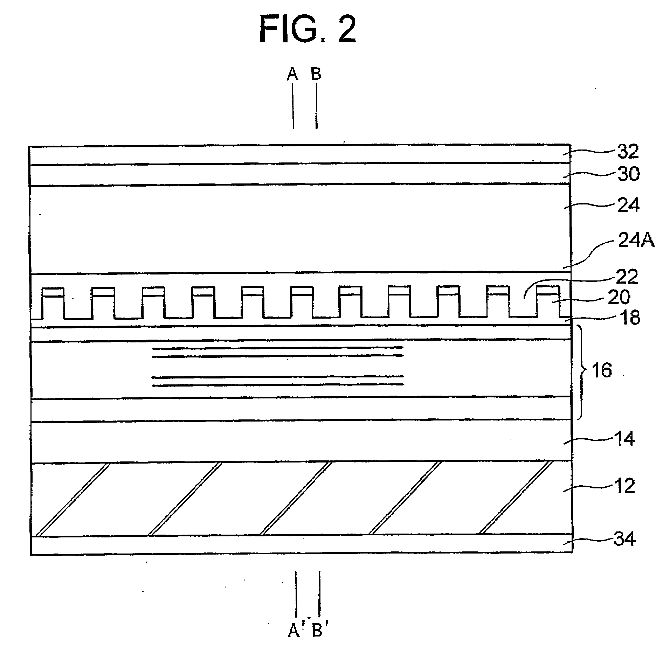

A DFB laser 10 of an embodiment of the present invention is, as shown in Figs.1 and 2, a complex-coupled DFB laser having an absorptive diffraction grating and an emission wavelength of 1550 nm. The DFB laser 10 includes a layered structure having an n-type InP buffer layer 14, an MQW-SCH active layer 16 having a bandgap of about 1560 nm when converted into a wavelength, a p-type InP spacer layer 18, diffraction gratings 20, an InGaAsP buried layer 22 filled in spaces between the adjacent diffraction gratings 20 and a p-type InP cladding layer 24A overlying an n-type InP substrate 12.

The top parts of the p-type InP cladding layer 24A, the InGaAsP layer 22, the diffraction gratings 20, the MQW-SCH active layer 16 and the n-type InP buffer layer 14 in the layered structure are etched to form a mesa stripe such that the width of the active layer is adjusted to be about 1.5 μm.

The side surfaces of the mesa stripes are filled with a p-type InP layer 26 and an n-type InP layer 28 acting as current blocking layers.

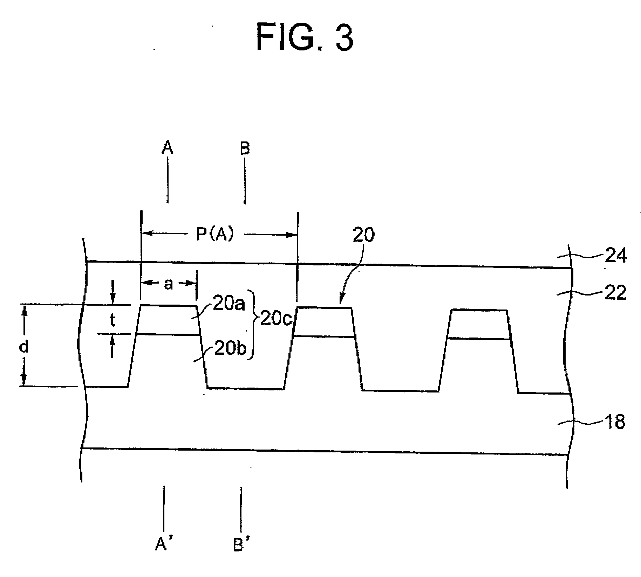

As shown in Figs.2 and 3, the diffraction grating 20 includes a plurality of grating layers 20c and an InGaAsP layer 22 which buries the grating layers 20c. Each of the grating layers 20c having a height (d) of 60 nm includes a p-type InGaAs layer 20a having a film thickness (t) of 20 nm and acting as an absorption layer and a p-type InP layer 20b having a film thickness (d-t) of 40 nm and acting as an underlying layer of the absorption layer 20a. The bottom InP layer 20b is formed by etching the top part of the spacer layer 18.

The pitch (P) of the diffraction layer 20c or the cycle (λ) of the diffraction grating 20 is 240nm, and the width (a) of the diffraction layer 20c is 60 nm. Then, the duty ratio expressed by $(a \ni \lambda) \times 100$ is 25%.

In the present embodiment, no absorption loss of the emission wavelength is generated in the buried layer 22 by establishing the bandgap wavelength (bandgap converted into wavelength) of the InGaAsP buried layer 22 shorter than the emission wavelength (1550 nm) by about 100 nm in accordance with the adjustment of the composition of the buried layer 22.

The refractive index of the InGaAsP ($n_{InGaAaP}$) of the buried layer 22 is adjusted to be 3.46.

The diffraction grating 20 of the present embodiment is configured to be the absorptive diffraction grating in which the refractive index and the gain are periodically changed.

When the light confinement distributions of the above diffraction grating 20 are assumed to be equal on both of the sections A-A' and B-B' of Figs.2 and 3, respectively, the equivalent refractive index of the B-B' section around the grating layer 20c or the equivalent refractive index of the buried layer 22 is larger than the equivalent refractive index of the A-A' section or the equivalent refractive index of the grating layer 20c. Accordingly, the following condition holds to realize the in-phase structure, wherein $n_{InGaAsP}$ is the refractive index of the InGaASP of the buried layer and equals to 3.46, $n_{InGaAs}$ is the refractive index of the InGaAs of the absorption layer and equals to 3.54, $n_{InP}$ is the refractive index of the InP and equals to 3.17, "t" is the thickness of the InGaAs absorption layer and equals to 20 nm, and "d" is the thickness of the grating layer and equals to 60 nm.

$$T \times n_{InGaAs} + (d-t) \times n_{InP} < d \times n_{InGaAsP} \qquad (1)$$

A three-layered grating layer may be formed by adding a top layer made by the same material as that of the underlying layer 20b on the absorption layer 20a.

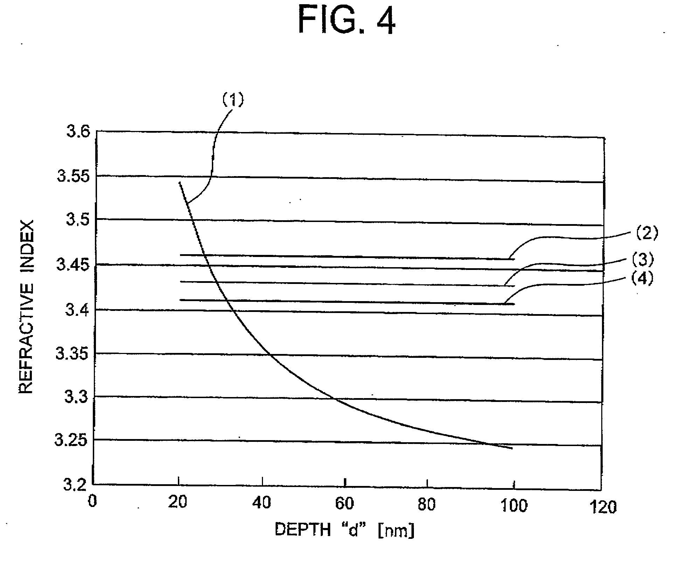

The relation that the equivalent refractive index of the buried layer 22 is larger than the equivalent refractive index of the grating layer 20c is shown in a graph of Fig.4.

In the graph, a slanted line (1) shows the relation between the height of the grating layer 20c or the depth from the top surface ("d", refer to Fig.3) and the equivalent refractive index of the section A-A' of the grating layer 20c. Horizontal lines (2), (3) and (4) show that the equivalent refractive indexes ($n_{InGaAsP}$) of the buried layer 22 are 3.46, 3.43 and 3.41, respectively. In other words, the graph of Fig.4 shows that the decrease of the equivalent refractive index ($n_{InGaAsP}$) of the buried layer requires the increase of the depth "d" of the grating layer 20c.

In the present embodiment, the above equation (1) holds provided that the $n_{InGaAsP}$ is 3.46 and the depth "d" of the grating layer 20c is larger than about 25 nm which is the value of the depth corresponding to the intersection between the slanted line (1) and the horizontal line (2) in the graph.

In the layered structure shown in Figs.1 to 3, a re-grown layer 24 having a thickness of about 2 μm for the p-type InP cladding layer and a p-type InGaAs cap layer 30 deeply doped for obtaining contact with a metal electrode are deposited on the p-type InP cladding layer 24A and the n-type InP layer 28 of the mesa structure.

A Ti/Pt/Au multi-layered metal film acting as a p-side electrode 32 is formed on the a p-type cap layer 30, and an AuGeNi film acting as an n-side electrode 34 is formed on the bottom surface of the n-type InP substrate 12.

Then, the wafer having the above configuration is cleaved to make bars, and an anti-reflection film (AR film) is coated on one end of the bar and a high reflection film (HR film) is coated on the other end of the bar. Thereby, the laser output is efficiently taken out from the front facet to realize the higher output.

Thereafter, the bar is chipped and bonded to the stem of a can package to provide a complex-coupled DFB laser product.

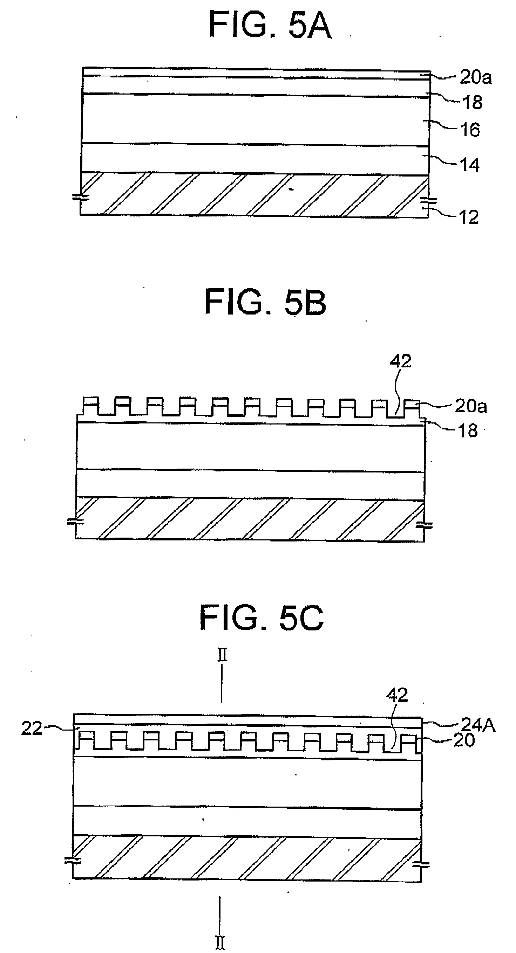

Then, a method for fabricating the DFB laser of the present embodiment will be described referring to Figs. 5A to 5F.

As shown in Fig.5A, the n-type InP buffer layer 14, the MQW-SCH active layer 16, the p-type InP spacer layer 18 having a thickness of 200 nm and the InGaAs absorption layer 20a having a thickness of 20 nm are sequentially and epitaxially grown overlying the n-type InP substrate 12 to form the layered structure by using an MOCVD crystal growth apparatus at a temperature of 600 °K. The bandgap wavelength of the active layer is about 1560 nm.

Then, the InGaAs absorption layer 20a and the InP spacer layer 18 are etched such that the InP spacer layer 18 is etched to the depth of 40 nm by means of the dry etching method by using an etching mask (not shown) having a specified pattern formed with an electron beam lithography system. Thereby, as shown in Fig.5B, the grating layer 20a having a height of 60 nm and trenches 42 having a depth of 60 nm are formed. The duty ratio of the diffraction grating is about 25 %.

Then, as shown in Fig.5C, the InGaAsP layer 22 is re-grown to fill the trenches 42 by using the MOCVD apparatus.

At this stage, the bandgap wavelength of the InGaAsP layer 22 to fill the trenches 42 is made to be shorter than the emission wavelength by about 100 nm, thereby generating no absorption loss in the buried layer 22. In the present embodiment, the refractive index of the InGaAsP ($n_{InGaAsP}$) is adjusted to be 3.46 at the emission wavelength of 1.55 μm.

Then, the p-type InP cladding layer 24A acting as the top cladding layer is deposited.

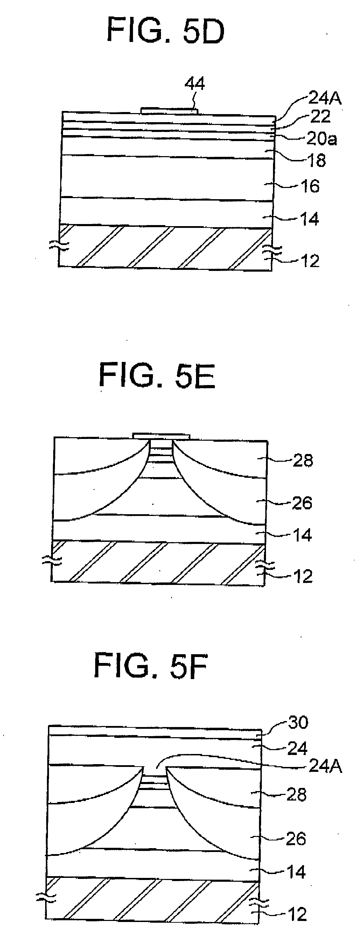

Thereafter, an SiNx film is deposited on the whole substrate surface by using the plasma CVD apparatus, and as shown in Fig.5D, the SiNx film is processed to a stripe having a width of 4 μm by means of the lithographic treatment and RIE to form an SiNx mask 44.

As shown in Fig.5E, the p-type cladding layer 24A, the buried layer 22, the diffraction grating 20, the active layer 16 and the bottom cladding layer (n-type InP buffer layer) 14 are etched by using the SiNx mask 44 as the etching mask, thereby providing the mesa stripe having the active layer width of about 1.5 μm.

Next, the p-type InP layer 26 and the n-type InP layer 28 are grown to fill the mesa stripe by using the SiNx etching mask 44 as a selective growth mask, thereby forming a carrier blocking layer.

Then, as shown in Fig.5F, after removal of the SiNx mask 44, the p-type InP cladding layer 24 having a thickness of about 2 μm is re-grown on the n-type InP layer 28 and the p-type InP cladding layer 24A, and the p-type InGaAs cap layer 30 deeply doped is grown for obtaining contact with the electrode.

The thickness of the substrate is adjusted to be about 120 μm by polishing the bottom surface of the n-type InP substrate 12. The Ti/Pt/Au metal multi-layered film acting as the p-side electrode 32 is formed on the cap layer 30, and the AuGeNi metal film acting as the n-side electrode 34 is formed on the bottom surface of the n-type InP substrate 12.

### Evaluation Test of DFB laser of Present Embodiment

One hundred (100) pieces of DFB laser devices having the same configuration as that of the above DFB laser were fabricated in accordance with the above procedures.

The 100 DFB laser devices were operated, and 90 % or more of the DFB laser devices excellently lased in a single mode. These DFB laser devices had a large side mode suppression ratio as high as 45 to 50 dB, and a threshold current was as low as about 9mA.

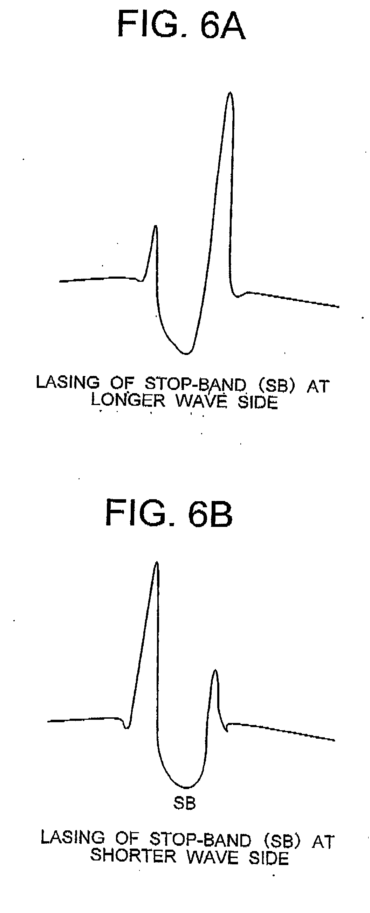

As shown in Fig.6A, the lasing was observed at the longer wave side than the Bragg's wavelength (stop-band (SB)) in 80 pieces or more of the DFB laser devices, and almost all of them generated no unstable operations such as the multi-mode lasing and the mode hopping.

Then, 100 pieces of conventional DFB laser devices were fabricated having the same configuration as the above DFB laser device of the present embodiment except that the space around the grating layer 20c of the diffraction grating 20 was filled with InP in place of the InGaAsP for the comparison of performances.

The conventional DFB laser devices were evaluated similarly to the DFB laser devices of the present embodiment. Although the conventional DFB laser devices also lased excellently in a single mode and had a large sub-mode suppression ratio as high as 45 to 50 dB, most of them lased at the shorter side than the Bragg's wavelength (stop-band (SB)) as shown in Fig.

6B. Under the condition of the higher injected current 40 times the threshold current, the 40 conventional DFB laser devices generated the multi-mode lasing and the mode hopping. The threshold current was as low as about 9 mA.

In accordance with the evaluation test, the DFB laser device of the present embodiment had the more excellent single mode property and was fabricated at the higher product yield compared with the conventional DFB laser device. This is because the emission wavelength was adjusted to be longer than the Bragg's wavelength.

Since the above embodiment is described only for examples, the present invention is not limited to the above embodiment and various modifications or alterations can be easily made therefrom by those skilled in the art without departing from the scope of the present invention.

## Claims

1. A complex-coupled distributed feedback (DFB) laser device (10) **characterized by** comprising:

    an active layer (16) disposed in a resonant cavity and configured to lase at a predetermined emission wavelength; and
    a diffraction grating (20) disposed on the active layer (16), where the diffraction grating (20) includes alternately

    a grating layer (20c) having an absorption layer (20a) configured to absorb an oscillation wavelength and
    a buried layer (22) filled in a space around the grating layer and configured to have a buried layer equivalent refractive index higher than a grating layer equivalent refractive index and a buried layer bandgap wavelength smaller than an active layer bandgap wavelength.

2. The complex-coupled DFB laser device (10) according to claim 1, wherein:

    the buried layer bandgap wavelength is lower than the active layer bandgap wavelength by a range inclusive of 50 nm through 300 nm.

3. The complex-coupled DFB laser device (10) according to claim 1, wherein:

    the grating layer (20c) is configured with an underlying layer (20b) under the absorption layer (20a);
    the absorption layer (20a) is configured to have a thickness $t_1$ and a refractive index $n_u$, and the underlying layer (20b) is configured to have a thickness $t_2$ and a refractive index $n_u$;
    the grating layer (20c) is configured to have a depth of d, where $d = t_1 + t_2$;
    the buried layer (22) is configured to have a refractive index $n_b$ smaller than the refractive index $n_a$ of the absorption layer (20a) and larger than the refractive index $n_u$ of the underlying layer (20b); and
    the grating layer (20c) is configured such that $d \times n_b > t_1 \times n_a + (d - t_1) \times n_u$.

4. The complex-coupled DFB laser device (10) according to claim 3, wherein:

    the grating layer (20c) includes a top layer configured to have a thickness of $d - t_1 - t_2$ and a refractive index of $n_t$; and
    the grating layer (20c) is configured such that $d \times n_b > t_1 \times n_a + (d - t_1) \times n_u + (d - t_1 - t_2) \times n_t$.

5. The complex-coupled DFB laser device (10) according to claim 1, wherein:

    the buried layer (22) includes at least two layers.

6. The complex-coupled DFB laser device (10) according to claim 1, wherein:

    the complex-coupled DFB laser device (10) is configured to have an emission wavelength longer than a Bragg's wavelength.

7. The complex-coupled DFB laser device (10) according to claim 1, wherein:

    the complex-coupled DFB laser device (10) is configured to have a finite, non-zero real part of a complex refractive index.

8. The complex-coupled DFB laser device (10) according to claim 1, wherein:

    the active layer (16) is an MQW-SCH active layer.

9. The complex-coupled DFB laser device (10) according to claim 1, further comprising:

    a p-type InP cladding layer (24) disposed on the buried layer (22);
    a p-type InGaAs cap layer (30) disposed on the p-type InP cladding layer (24);
    a Ti/Pt/Au metal film (32) disposed on the p-type InGaAs cap layer (30);
    a p-type InP spacer layer (18) on which the diffraction grating (20) is disposed;

an n-type InP buffer layer (14) on which the p-type InP spacer layer (18) is disposed;
an n-type InP substrate (12)on which the n-type InP buffer (14) is disposed; and
a AuGeNi metal film (34) on which the n-type InP substrate (12) is disposed.

10. The complex-coupled DFB laser device (10) according to claim 9, wherein:

the p-type InP cladding layer (24), the buried layer (22), the grating layer (20c), the p-type InP spacer layer (18), and the active layer (16) are configured to form a mesa stripe.

11. The complex-coupled DFB laser device (10) according to claim 10, wherein:

the active layer (16) in the mesa stripe is configured to have a width within a range of 1.5:m and 2.5:m.

12. The complex-coupled DFB laser device (10) according to claim 10, wherein:

an area abutting a side surface of the mesa stripe is filled with a p-type InP layer (26) and an n-type InP layer (28) configured to act as current blocking layer.

13. The complex-coupled DFB laser device (10) according to claim 1, wherein:

the buried layer (22) is an InGaAsP layer.

14. The complex-coupled DFB laser device (10) according to claim 3, wherein:

the absorption layer (20a) is a p-type InGaAs layer configured to have a thickness $t_1$ of 20 nm and a refractive index $n_a$ of 3.54;
the underlying layer (20b) is a p-type InP layer configured to have a thickness $t_2$ of 40 nm and a refractive index $n_u$ of 3.17; and
the buried layer (22) is a InGaAsP layer is configured to have a refractive index $n_b$ of 3.46.

15. The complex-coupled DFB laser device (10) according to claim 3, wherein:

the diffraction grating (20) has a duty ratio between 20% and 40%.

16. The complex-coupled DFB laser device (10) according to claim 3, wherein:

the active layer (16) is configured to have an emission wavelength of 1550 nm and a bandgap wavelength of about 1560 nm; and
the buried layer (22) is configured to have a bandgap wavelength of 1540 nm.

17. The complex-coupled DFB laser device (10) according to claim 1, further comprising:

an anti-reflection film configured to have a reflectivity coefficient of less than 5% coated on one end of the resonant cavity; and
a high reflection film configured to have a reflectivity coefficient of more than 80% coated on an other end of the resonant cavity.

18. The complex-coupled DFB laser device (10) according to claim 1, wherein:

the diffraction grating (20) is configured to be an absorptive diffraction grating in which a refractive index and a gain are periodically changed.

19. A complex-coupled DFB laser device (10), **characterized by** comprising:

means for producing a light under high current injection at a predetermined emission wavelength;
means for stabilizing the light in a single mode at a wavelength longer than a Bragg's wavelength while suppressing at least one of multi-mode lasing and mode hopping; and
means for emitting the single mode of the light.

20. A method for emitting lased light (10), **characterized by** comprising steps of:

producing a light under high current injection at a predetermined emission wavelength;
stabilizing the light in a single mode at a wavelength longer than a Bragg's wavelength while suppressing at least one of multi-mode lasing and mode hopping; and
emitting the single mode of light.

21. The method for emitting lased light according to claim 20, wherein:

said stabilizing step includes subjecting the light to a diffraction grating (20) which includes alternately

a grating layer (20c) having an absorption layer (20a) configured to absorb an oscillation wavelength, and
a buried layer (22) filled in a space around the grating layer (20c) and configured to have an equivalent refractive index higher than that of the grating layer (20c) and bandgap wavelength smaller than that of the active layer (16).

22. A method of manufacturing a complex-coupled distributed feedback (DFB) laser device (10), **characterized by** comprising steps of:

growing predetermined layers on a substrate (12) including substeps of
epitaxially growing a buffer layer (14) onto the substrate (12);
epitaxially growing an active layer (16) onto the buffer layer (14);
epitaxially growing a spacer layer (18) onto the active layer (16);
epitaxially growing an absorption layer (20a) onto the spacer layer (18); and
forming a diffraction grating (20) in the spacer layer (18) and the absorption layer (20a) with a predetermined diffraction grating duty ratio and a predetermined diffraction grating depth, wherein said forming step includes forming the diffraction grating (20) to absorb an oscillation wavelength.

23. A method of manufacturing a complex-coupled distributed feedback (DFB) laser device (10) according to claim 22, wherein:

said substrate (12) is an n type InP material;
said epitaxially growing a buffer layer step includes forming the buffer layer (14) with an n-type InP material;
said epitaxially growing an active layer step includes forming the active layer (16) with an MQW-SCH material with a bandgap wavelength of 1560 nm;
said epitaxially growing a spacer layer step includes forming the spacer layer (18) with a p-type InP material and controlling a spacer layer thickness to 200 nm;
said epitaxially growing an absorption layer step includes forming the absorption layer (20a) with an InGaAs material and controlling an absorption layer thickness to 20 nm; and
said forming a diffraction grating step includes controlling a diffraction grating duty cycle and a diffraction grating depth so that the predetermined diffraction grating duty cycle is 25% and the predetermined diffraction grating depth is 60 nm.

24. A method of manufacturing a complex-coupled distributed feedback (DFB) laser device (10) according to claim 22, wherein:

said forming a diffraction grating step includes etching the absorption layer (20a) and the spacer layer (18) such that the absorption layer (20a) is completely etched and the spacer layer (18) is etched to a predetermined spacer layer trench depth.

25. A method of manufacturing a complex-coupled distributed feedback (DFB) laser device (10) according to claim 24, wherein:

said etching step includes controlling a depth of etching so the spacer layer (18) is etched to 40 nm.

26. A method of manufacturing a complex-coupled distributed feedback (DFB) laser device (10) according to claim 22, wherein:

said growing step includes growing the predetermined layers in a MOCVD crystal growth apparatus at a temperature of 600K.

27. A method of manufacturing a complex-coupled distributed feedback (DFB) laser device (10) according to claim 22, wherein;

said forming a diffraction grating step includes etching with a dry etching method and using a predetermined pattern formed with an electron beam lithography system.

28. A method of manufacturing a complex-coupled distributed feedback (DFB) laser device (10) according to claim 22, further comprising steps of:

regrowing the absorption layer (20a) to fill the diffraction grating (20) so as to form a regrown absorption layer (20a);
shortening a bandgap wavelength of the buried layer (22) such that the bandgap wavelength of the absorption layer (20a) is shorter than an emission wavelength of the active layer (16) by 100 nm; and
depositing a cladding layer (24) on the regrown absorption layer (20a).

29. A method of manufacturing a complex-coupled distributed feedback (DFB) laser device (10) according to claim 28, wherein:

said regrowing absorption layer step includes regrowing the absorption layer (20a) in a MOCVD apparatus.

30. A method of manufacturing a complex-coupled distributed feedback (DFB) laser device (10) according to claim 28, wherein:

said shortening step includes controlling a refractive index of the buried layer (22) so that the buried layer (22) has an buried layer refractive index of 3.46.

31. A method of manufacturing a complex-coupled distributed feedback (DFB) laser device (10) according to claim 28, further comprising steps of:

depositing an etching mask on the cladding layer (24);
forming a mesa stripe including the etching mask, the cladding layer (24), the absorption layer (20a), the diffraction grating (20), the spacer layer (18), the active layer (16) and the buffer layer (14); and
forming a carrier blocking layer around the mesa stripe.

32. A method of manufacturing a complex-coupled distributed feedback (DFB) laser device (10) according to claim 31, wherein:

said depositing a mask step includes depositing material with a plasma CVD apparatus.

33. A method of manufacturing a complex-coupled distributed feedback (DFB) laser device (10) according to claim 31, wherein:

said forming a carrier blocking layer step includes using the etching mask as a selective growth mask.

34. A method of manufacturing a complex-coupled distributed feedback (DFB) laser device (10) according to claim 31, wherein:

said depositing an etching mask step includes controlling a width of masking to produce a mask with a width in a range of 4 :m to 5 :m;
said forming a mesa stripe step includes controlling a width of striping to provide a mesa stripe having an active layer width in a range of 1.5:m to 2.0:m; and
said forming a carrier blocking layer step includes sequentially growing a p-type InP layer (26) and an n-type InP layer (28).

35. A method of manufacturing a complex-coupled distributed feedback (DFB) laser device (10) according to claim 31, further comprising steps of:

removing the etching mask;
growing another portion of cladding onto the carrier blocking layer and a pre-existing portion of the cladding layer (24) to form a regrown cladding layer (24);

growing a deeply doped cap layer (30) onto the regrown cladding layer (24);
adjusting the thickness of the substrate (12), wherein said adjusting the thickness of the substrate step includes polishing the substrate (12);
forming a p-side electrode (32) on the deeply doped cap layer (30); and
forming an n-side electrode (34) on a bottom of the substrate layer (12) so as to create a wafer.

36. A method of manufacturing a complex-coupled distribueed feedback (DFB) laser device (10) according to claim 35, wherein:

said adjusting step includes controlling a thickness of substrate (12) so as to form a substrate thickness of 120 :m;
said forming a p-side electrode step includes depositing a Ti/Pt/Au multi-layered film;
said forming an n-side electode step includes depositing a AuGeNi multi-layered film.

37. A method of manufacturing a complex-coupled distributed feedback (DFB) laser device (10) according to claim 35, further comprising steps of:

cleaving the wafer to make a bar;
coating one end of the bar with an anti-reflection film;
coating an other end of the bar with a high reflection film;
chipping the bar; and
bonding the bar to a stem of a can package so as to form the complex-coupled distributed feedback (DFB) laser device (10).

# FIG. 1

EP 1 227 556 A2

FIG. 2

# FIG. 3

EP 1 227 556 A2

## FIG. 4

# FIG. 5A

20a
18
16
14
12

# FIG. 5B

42
20a
18

# FIG. 5C

II

42
24A
20
22

II

# FIG. 5D

# FIG. 5E

# FIG. 5F

# FIG. 6A

LASING OF STOP-BAND (SB) AT
LONGER WAVE SIDE

# FIG. 6B

SB

LASING OF STOP-BAND (SB) AT
SHORTER WAVE SIDE